(19) **Europäisches Patentamt**

**European Patent Office**

**Office européen des brevets**

(11) **EP 1 630 964 A2**

(12) **EUROPEAN PATENT APPLICATION**

(43) Date of publication:
01.03.2006 Bulletin 2006/09

(51) Int Cl.:
*H03M 1/10* (2006.01)

(21) Application number: 05018301.1

(22) Date of filing: **23.08.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **26.08.2004 JP 2004246850**

(71) Applicant: **MATSUSHITA ELECTRIC INDUSTRIAL CO., LTD.**
**Kadoma-shi, Osaka 571-8501 (JP)**

(72) Inventors:
• **Dosho, Shiro**
**Ikeda-shi**
**Osaka 563-0024 (JP)**

• **Morie, Takashi**
**Ibaraki-shi**
**Osaka 567-0851 (JP)**
• **Ogita, Shinichi**
**Yawata-shi**
**Kyoto 614-8325 (JP)**
• **Ohtani, Mitsuhiko**
**Amagasaki-shi**
**Hyogo 661-0953 (JP)**

(74) Representative: **Grünecker, Kinkeldey,**
**Stockmair & Schwanhäusser**
**Anwaltssozietät**
**Maximilianstrasse 58**
**80538 München (DE)**

(54) **Pipelined A/D converter and method for correcting error in output of the same**

(57) Two capacitors in a variable stage are controlled from outside to function as a feedback capacitor and a sampling capacitor, respectively. With a test signal being supplied to the variable stage from an input selecting section, a stage evaluation section estimates an error in the output of the variable stage based on a difference between the digital outputs of an output correction section produced in two situations in which the functions of the two capacitors in the variable stage are switched. A correction value calculation section calculates a digital correction value for each variable stage based on the estimated error and an intermediate output of a digital calculation section. The output correction section corrects the digital output of the digital calculation section based on these digital correction values.

FIG. 1

EP 1 630 964 A2

**Description**

**CROSS-REFERENCE TO RELATED APPLICATION**

This application is related to Japanese Patent Application No. 2004-246850 filed on August 26, 2004, whose priority is claimed under 35 USC §119, the disclosure of which is incorporated herein by reference in its entirety.

**BACKGROUND OF THE INVENTION**

The present invention relates to a pipelined A/D converter, and more particularly relates to a technology of correcting the output of an A/D converter.

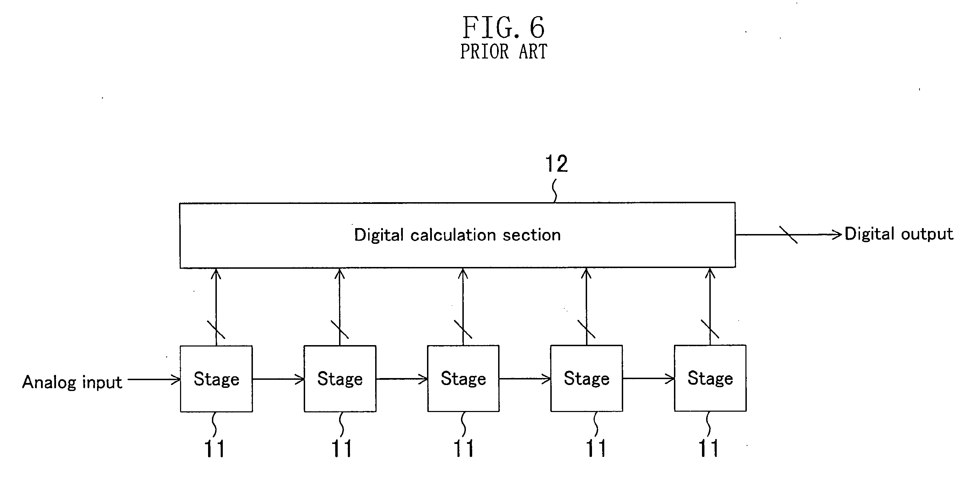

FIG. 6 illustrates the configuration of a conventional pipelined A/D converter. The pipelined A/D converter typically includes a plurality of cascade-connected stages **11** and a digital calculation section **12.** Each stage **11** converts an input analog signal to digital form and outputs the obtained digital signal to the digital calculation section **12,** while outputting to the successive stage **11** an analog signal, which is obtained by subtracting an analog value corresponding to the digital signal from the input analog signal and then doubling the resultant value. The digital calculation section **12** shifts each of the digital signals received from the respective stages **11** by one bit and adds the resultant digital values together, thereby generating the digital output of the pipelined A/D converter.

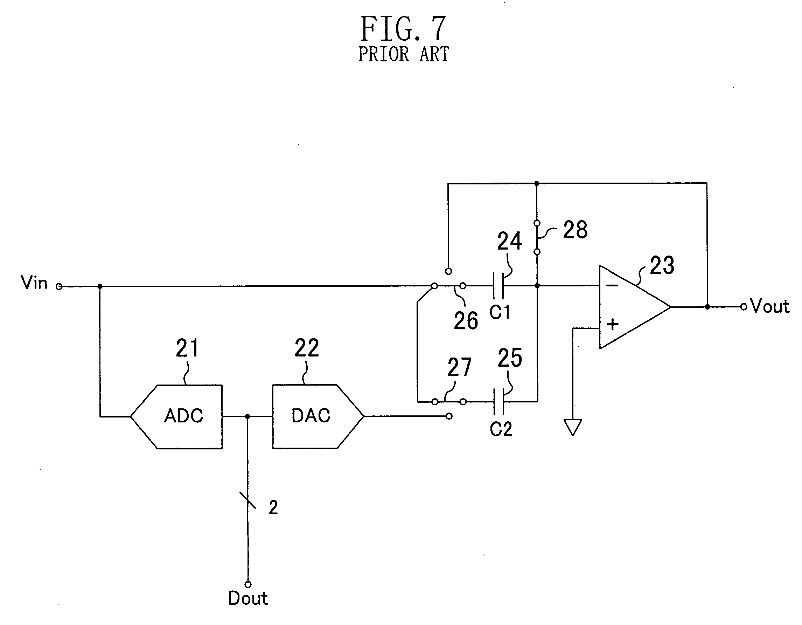

As the stages **11,** so-called 1.5-bit stages are typically used (see, for example, a doctoral dissertation by Shingo Hatanaka, "Study of the design of low-voltage, high-precision pipelined A/D converter" (Osaka University, 2002)). FIG. 7 illustrates the circuit configuration of a conventional 1.5-bit stage. An A/D converter **21** converts an analog signal **Vin** to digital form, thereby generating a digital signal **Dout.** A D/A converter **22** converts the digital signal **Dout** to analog form. Capacitors **24** and **25** are each connected at one end to the inverting input terminal of an operational amplifier **23,** while a reference potential is supplied to the non-inverting input terminal of the operational amplifier **23.** A switch **26,** controlled from outside, switches between the input terminal of the analog signal **Vin** and the output terminal of the operational amplifier **23,** so that the other end of the capacitor **24** is connected to either of these terminals. That is, the switch **26** and the capacitor **24** operate as a switched capacitor circuit, and the capacitor **24** is used for feedback of the operational amplifier **23.** Hereinafter, such a capacitor will be referred to as a "feedback capacitor". Likewise, a switch **27,** controlled from outside, switches between the input terminal of the analog signal **Vin** and the output terminal of the D/A converter **22,** so that the other end of the capacitor **25** is connected to either of these terminals. That is, the switch **27** and the capacitor **25** operate as a switched capacitor circuit, and the capacitor **25** is used for output sampling of the D/A converter **22.** Hereinafter, such a capacitor will be referred to as a "sampling capacitor". A switch **28,** controlled by a control section, opens/closes the circuit between the inverting input terminal and the output terminal of the operational amplifier **23.**

The 1.5-bit stage operates as follows. A state, in which the switch **28** is closed and the capacitors **24** and **25** are each connected at the other end to the input terminal of the analog signal **Vin,** and a state, in which the switch **28** is opened and the capacitors **24** and **25** are connected at the other end to the output terminal of the operational amplifier **23** and to the output terminal of the D/A converter **22,** respectively, are repeated alternately, whereby an analog signal **Vout**, which is input to the successive stage, is generated.

If the capacity values of the capacitors **24** and **25** are represented by C1 and C2, respectively, the analog input/ output characteristics of the 1.5-bit stage are expressed as the following function.

$$
Vout=
\begin{cases}
(1+\dfrac{C2}{C1})\,Vin + \dfrac{C2}{C1}\,Vref & (-Vref \ \leqq\ Vin\ \leqq\ -\dfrac{Vref}{4}\ ) \\[2mm]
(1+\dfrac{C2}{C1})\,Vin & (-\dfrac{Vref}{4}\ \leqq\ Vin\ \leqq\ \dfrac{Vref}{4}\ ) \\[2mm]
(1+\dfrac{C2}{C1})\,Vin - \dfrac{C2}{C1}\,Vref & (\ \dfrac{Vref}{4}\ \leqq\ Vin\ \leqq\ Vref\ )
\end{cases}
$$

where Vref is the maximum amplitude of the analog signal **Vin.**

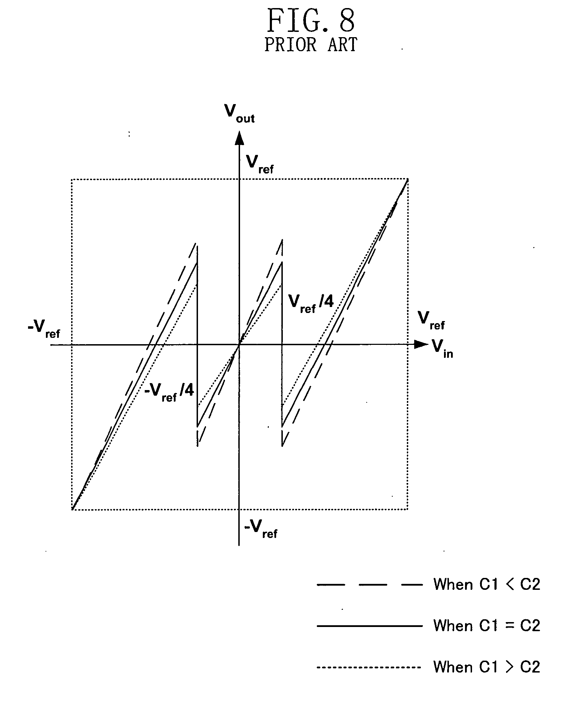

FIG. **8** is a graph indicating the analog input/output characteristics of the 1.5-bit stage. The horizontal axis represents the level of the input analog signal, and the vertical axis indicates the level of the output analog signal. When -Vref ≤ Vin ≤ -Vref/4, the digital output of the 1.5-bit stage is "0b00"; when -Vref/4 ≤ Vin ≤ Vref/4, the digital output thereof is "0b01"; and when Vref/4 ≤ Vin ≤ Vref, the digital output thereof is "0b10".

When the capacity value of the feedback capacitor is equal to that of the sampling capacitor, that is, when C1 = C2, the analog input/output characteristics of the 1.5-bit stage take desired values. Specifically, the gain of the operational amplifier **23** becomes "2", and the discontinuity width in the nonlinear portions (i.e., the portions in which Vin = ±Vref/4) in the function is Vref, which corresponds to one bit.

However, it is very difficult to make the feedback and sampling capacitors have the same capacity value, so there is actually some difference in capacity value between these capacitors. This capacity value difference results in an error in the gain, thereby causing the analog input/output characteristic of the stage to change. More specifically, when the sampling capacitor has a larger capacity value than the feedback capacitor (i.e., when C1 < C2), the discontinuity width becomes greater than one bit. When the sampling capacitor has a smaller capacity value than the feedback capacitor (i.e., when C1 > C2), the discontinuity width becomes smaller than one bit.

When the discontinuity width exceeds one bit, a repeat code, a code repeated multiple times, occurs as an output error of the pipelined A/D converter. On the other hand, when the discontinuity width is smaller than one bit, a missing code, a specific code that is not output, occurs. Empirically, correction of a missing code is easier than that of a repeat code. Therefore, in the pipelined A/D converter, the sampling capacitor is preferably smaller in capacity value than the feedback capacitor at least in the first several stages. Nevertheless, the conventional pipelined A/D converter finds difficulty in discriminating which of these capacitors has a larger capacity value and which has a smaller capacity value, and changing them dynamically.

Furthermore, at present it is known that the capacity value difference is the main cause for deterioration of the analog input/output characteristics of the stages and that the elimination of this difference leads to improvements in the INL (integral non-linearity) performance of the pipelined A/D converter. However, in the case of a pipelined A/D converter having a resolution of 12 bits or more, the allowable difference is about 0.04 % or less. It is very difficult to correct such a difference within the analog signal range, and difference correction by digital processing is thus required.

## SUMMARY OF THE INVENTION

In view of the above problems, it is therefore an object of the present invention to provide a pipelined A/D converter in which the type of output error can be controlled. Furthermore, another object of the present invention is to correct, by digital processing, an error in the output of the pipelined A/D converter caused by a difference in capacity value between a feedback capacitor and a sampling capacitor.

In order to achieve the above objects, an inventive pipelined A/D converter includes a plurality of cascade-connected stages, wherein at least one of the stages is a variable stage that includes: an A/D converter for converting an analog input to the variable stage to digital form; a D/A converter for converting a digital output of the A/D converter to analog form; an operational amplifier; first and second capacitors; and a set of switches for selecting, as a connection state for the first and second capacitors, either a first connection state, in which the first capacitor is used for feedback of the operational amplifier and the second capacitor is used for output sampling of the D/A converter, or a second connection state that is opposite to the first connection state.

In the inventive pipelined A/D converter, it is possible to select which of the first and second capacitors in the variable stage functions as a feedback capacitor and which functions as a sampling capacitor, thereby controlling the type of error occurring in the output of the pipelined A/D converter. For example, when the first and second capacitors are put in the connection state that makes the sampling capacitor have a smaller capacity value than the feedback capacitor, the error in the output of the pipelined A/D converter is a missing code.

The inventive pipelined A/D converter preferably further includes: a digital calculation section for sequentially shifting digital outputs of the respective stages and adding resultant shifted digital values together; an input selecting section for selecting either a normal input signal or a test signal as the analog input to the variable stage; a stage evaluation section for estimating an error in an analog output of the variable stage, the error resulting from a difference in capacity value between the first and second capacitors; a correction value calculation section for calculating a digital correction value for correcting a digital output of the digital calculation section, based on an intermediate output of the digital calculation section and the analog output error estimated by the stage evaluation section; and an output correction section for correcting the digital output of the digital calculation section based on the digital correction value calculated by the correction value calculation section. Preferably, with the test signal being supplied to the variable stage, the stage evaluation section estimates the analog output error based on a difference between digital outputs of the digital calculation section or digital outputs of the output correction section produced when the first and second capacitors in the variable stage are put in the first connection state and when the first and second capacitors in the variable stage are put in the second connection state, respectively.

Then, the stage evaluation section estimates the error in the analog output of the variable stage based on a difference between the digital outputs of the digital calculation section or the digital outputs of the output correction section produced when the first and second capacitors in the variable stage are put in the first and second connection states. By using the difference between the digital outputs, errors caused by the other stages and contained in the digital outputs thereof are canceled out, such that the error of the target variable stage is reflected strongly. It is therefore possible to estimate an error in the analog output of any variable stage, regardless of the presence or absence of errors in the outputs of the other stages, thereby facilitating the error estimation process. The correction value calculation section then calculates the digital correction value based on the estimated analog output error and an intermediate output of the digital calculation section. Based on the digital correction value, the output correction section corrects the digital output of the digital calculation section. Since the intermediate output of the digital calculation section is used to calculate the digital correction value, the latency of the pipelined A/D converter does not deteriorate.

Also, the inventive pipelined A/D converter preferably further includes: an input selecting section for selecting either a normal input signal or a test signal as the analog input to the variable stage; a control section for controlling the set of switches in the variable stage; and a stage evaluation section for determining which of the first and second capacitors in the variable stage has a larger capacity value and which has a smaller capacity value. Preferably, with the test signal being supplied to the variable stage, the stage evaluation section makes the determination about the capacity values based on digital outputs of the pipelined A/D converter produced when the first and second capacitors in the variable stage are put in the first connection state and when the first and second capacitors in the variable stage are put in the second connection state, respectively; and preferably, the control section controls the set of switches in the variable stage, based on a result of the capacity-value determination made by the stage evaluation section, in such a manner that either of the first and second capacitors that has a larger capacity value is used for feedback of the operational amplifier.

Then, the stage evaluation section determines which of the first and second capacitors in the variable stage has a larger capacity value and which has a smaller capacity value, based on the outputs of the pipelined A/D converter produced when the first and second capacitors in the variable stage are put in the first and second connection states. And based on the result of this determination about the capacity values, the control section controls the set of switches in the variable stage in such a manner that either of the first and second capacitors that has a larger capacity value is used for feedback of the operational amplifier. As a result, the error in the output of the pipelined A/D converter is a missing code.

Moreover, in the inventive pipelined A/D converter, the test signal is preferably at a level that makes the level of analog input/output for stages successive to the variable stage into which the test signal is input be about a median value of a maximum amplitude of the analog input/output.

An inventive method for correcting an error in an output of the pipelined A/D converter includes: an input selecting step of selecting which signal is input to the variable stage; a connection state selecting step of performing switching between the first and second connection states for the first and second capacitors in the variable stage, with a test signal selected in the input selecting step being supplied to the variable stage; an error estimation step of estimating an error in an analog output of the variable stage caused by a difference in capacity value between the first and second capacitors, based on a difference between outputs of the pipelined A/D converter produced when the first and second capacitors are put in the first connection state and when the first and second capacitors are put in the second connection state, respectively, in the connection state selecting step; a correction value calculation step of calculating a digital correction value for correcting an output of the digital calculation section, based on an intermediate output of the digital calculation section and the analog output error estimated in the error estimation step; and an output correction step of correcting the digital output of the digital calculation section based on the digital correction value calculated in the correction value calculation step.

Then, in the error estimation step, an error in the analog output of the variable stage is estimated based on a difference between the digital outputs of the digital calculation section or the digital outputs of the output correction section produced when the first and second capacitors in the variable stage are put in the first and second connection states. By using the difference between the digital outputs, errors caused by the other stages and contained in the digital outputs thereof are canceled out, such that the error of the target variable stage is reflected strongly. It is therefore possible to estimate an error in the analog output of any variable stage, regardless of the presence or absence of errors in the outputs of the other stages, thereby facilitating the error estimation process. In the correction value calculation step, the digital correction value is calculated based on the estimated analog output error and an intermediate output of the digital calculation section. Then, in the output correction step, the digital output of the digital calculation section is corrected based on the digital correction value. Since the intermediate output of the digital calculation section is used in calculating the digital correction value, the latency of the pipelined A/D converter does not deteriorate.

As described above, according to the present invention, it is possible to control the type of error in the output of the pipelined A/D converter so that a missing code, which can be corrected relatively easily, occurs as an error in the output. Also, for correction of the output of the pipelined A/D converter, a digital correction value is calculated relatively easily for any variable stage. Furthermore, the INL performance of the pipelined A/D converter is improved without causing the latency of the pipelined A/D converter to deteriorate.

## BRIEF DESCRIPTION OF THE DRAWINGS

FIG. **1** illustrates the configuration of a pipelined A/D converter according to a first embodiment of the present invention.

FIG. **2** illustrates the internal configuration of a variable stage.

FIG. **3** is a graph indicating the analog-output error characteristics of the variable stage.

FIG. **4** is a flow chart indicating process steps for estimating an error in the analog output of the variable stage.

FIG. **5** illustrates the configuration of a pipelined A/D converter according to a second embodiment of the present invention.

FIG. **6** illustrates the configuration of a conventional pipelined A/D converter.

FIG. **7** illustrates the circuit structure of a conventional 1.5-bit stage.

FIG. **8** is a graph indicating the analog input/output characteristics of the conventional 1.5-bit stage.

## DESCRIPTION OF THE PREFERRED EMBODIMENTS

Hereinafter, preferred embodiments of the present invention will be described with reference to the accompanying drawings.

(First embodiment)

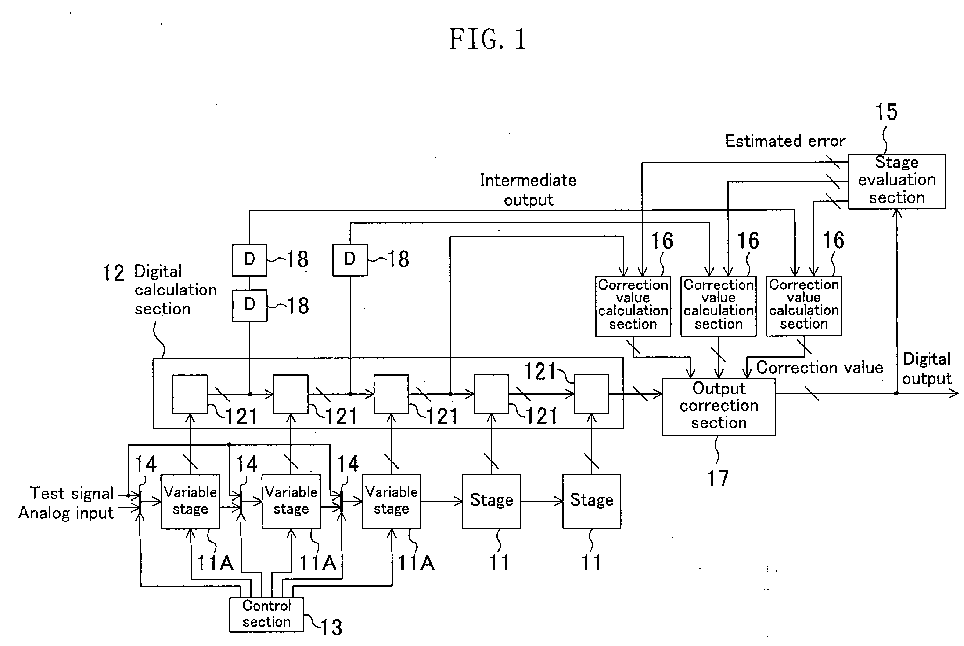

FIG. **1** illustrates the configuration of a pipelined A/D converter according to a first embodiment of the present invention. The pipelined A/D converter of this embodiment includes a plurality of cascade-connected 1.5-bit stages **11** and 1.5-bit variable stages **11A;** a digital calculation section **12;** a control section **13;** a plurality of input selecting sections **14;** a stage evaluation section **15;** a plurality of correction value calculation sections **16;** and an output correction section **17.** Of these members, the configurations of the stages **11** and digital calculation section **12** are similar to those in the conventional converter, and the descriptions thereof will be thus omitted herein. Hereinafter, the other members will be described in detail. It should be noted that the respective numbers of variable stages **11A,** stages **11,** and correction value calculation sections **16** shown in FIG **1** are given for the convenience of description, and therefore the present invention is not limited to the illustrated configurations.

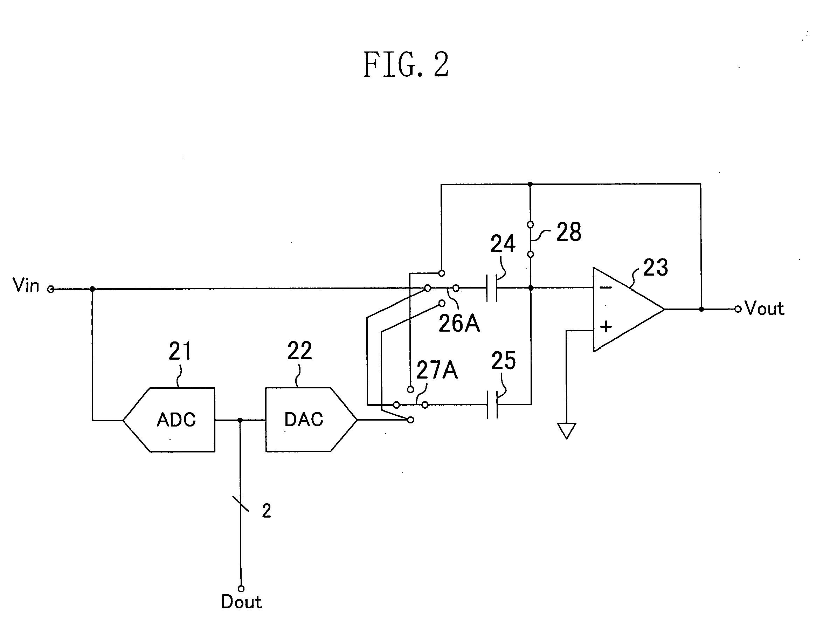

FIG. **2** illustrates the internal configuration of each variable stage **11A.** Each variable stage **11A** includes an A/D converter **21,** a D/A converter **22,** an operational amplifier **23,** capacitors **24** and **25,** and switches **26A, 27A,** and **28.** The A/D converter **21** converts an analog signal **Vin** to digital form, thereby generating a digital signal **Dout.** The D/A converter **22** converts the digital signal **Dout** to analog form. The capacitors **24** and **25** are each connected at one end to the inverting input terminal of the operational amplifier **23,** while a reference potential is supplied to the non-inverting input terminal of the operational amplifier **23.**

The switch **26A,** controlled by the control section **13,** switches among the input terminal of the analog signal **Vin,** the output terminal of the operational amplifier **23,** and the output terminal of the D/A converter **22,** so that the other end of the capacitor **24** is connected to one of these terminals. Similarly, the switch **27A,** controlled by the control section **13,** switches among the input terminal of the analog signal **Vin,** the output terminal of the operational amplifier **23,** and the output terminal of the D/A converter **22,** so that the other end of the capacitor **25** is connected to one of these terminals. The switch **28,** controlled by the control section, opens/closes the circuit between the inverting input terminal and the output terminal of the operational amplifier **23.**

The switches **26A, 27A,** and **28** provide the following two connection states for the capacitors **24** and **25.** In the first connection state, the capacitor **24** is used for feedback of the operational amplifier **23,** while the capacitor **25** is used for output sampling of the D/A converter **22.** In the second connection state, the capacitor **24** is used for output sampling of the D/A converter **22,** while the capacitor **25** is used for feedback of the operational amplifier **23.** More specifically, in the first connection state, a state, in which the switch **28** is closed and the capacitors **24** and **25** are each connected at the other end to the input terminal of the analog signal **Vin,** and a state, in which the switch **28** is opened and the capacitors **24** and **25** are connected at the other end to the output terminal of the operational amplifier **23** and to the output terminal of the D/A converter **22,** respectively, are repeated alternately. On the other hand, in the second connection state, a state, in which the switch **28** is closed and the capacitors **24** and **25** are each connected at the other end to the input terminal of the analog signal **Vin,** and a state, in which the switch **28** is opened and the capacitors **24** and **25** are connected at the other end to the output terminal of the D/A converter **22** and to the output terminal of the operational amplifier **23,** respectively, are repeated alternately. The selection between the first and second connection states is made under the control of the control section **13.** In this manner, in the variable stages **11A** the functions of the capacitors **24** and **25** can be switched under the control of the control section **13.**

It should be noted that the configurations of the switches **26A, 27A,** and **28** shown in FIG. **2** are just examples, and various other configurations may be adopted.

Referring back to FIG **1,** the control section **13** controls operation of each input selecting section **14** and operation of the set of switches in each variable stage **11A.**

The input selecting sections **14** are provided corresponding to the variable stages **11A,** and select, under the control of the control section **13,** which signal is input to the corresponding variable stage **11A.** Specifically, each input selecting section **14** selects a normal input signal or a test signal. In this embodiment, for the initial variable stage **11A,** the normal input signal is an analog input to the pipelined A/D converter, while for the second and successive variable stages **11A,** the normal input signal is the analog output from the variable stage **11A** prior to that stage. On the other hand, the test signal is an analog signal having a given size. The test signal may be generated by a not-shown D/A converter or the like.

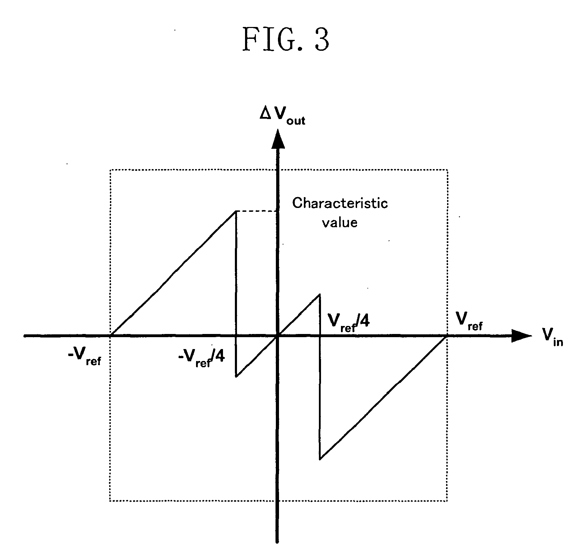

The stage evaluation section **15** estimates an error in the analog output of each variable stage **11A** based on the digital output of the output correction section **17.** Hereinafter, an error in the analog output of the variable stage **11A** will be discussed. When the feedback capacitor and the sampling capacitor in the variable stage **11A** have the same capacity value, the error in the analog output of the variable stage **11A** will be zero. However, as described above, there is actually a difference between the capacity values of these two capacitors. For example, when the feedback capacitor has a larger capacity value than the sampling capacitor, error characteristics such as shown in FIG. **3** are obtained. The horizontal axis represents the level of the analog input, while the vertical axis indicates the error in the analog output. Although the error characteristics differ from stage to stage, the characteristic graphs are similar to each other, and the only differences therebetween are the characteristic value, which is the biggest error, and the polarity. Therefore, if in each variable stage **11A** the connection state of the capacitors **24** and **25** is changed as appropriate to make the sampling capacitor and the feedback capacitor have the same capacity value, the analog output error characteristics of the variable stage **11A** are determined by the characteristic value alone.

More specifically, the characteristic value is estimated as follows. First, with a test signal being input to a variable stage **11A** whose characteristic value is to be estimated (an object variable stage **11A**), the digital output of the pipelined A/D converter, in which the capacitors **24** and **25** in the object variable stage **11A** are put in the first connection state, is obtained. Next, the digital output of the pipelined A/D converter, in which the capacitors **24** and **25** in the object variable stage **11A** are put in the second connection state, is obtained. The difference between these digital outputs is then calculated. The magnitude of this difference corresponds to a difference in capacity value between the feedback capacitor and the sampling capacitor. It is therefore possible to estimate the characteristic value of the object variable stage **11A** from this difference between the digital outputs. By calculating the difference between the digital outputs of the pipelined A/D converter obtained when the capacitors **24** and **25** are in the first and second connection states, errors in the digital outputs of the stages **11** and variable stages **11A** whose characteristic values are not to be estimated (non-object stages) are cancelled out. That is, by eliminating the effects of the errors in the outputs of the non-object stages, it becomes possible to estimate the characteristic value more precisely for any variable stage **11A.**

It is preferable that the difference-calculation step mentioned above be repeated multiple times (about a hundred times, for example) and that the characteristic value estimation be performed based on the multiple differences obtained by the repeated calculation steps. For example, those multiple differences are added together and the characteristic value may be estimated based on the resultant total value. This is because noise may be superimposed on the digital output of the pipelined A/D converter, and if the number of difference-calculation steps repeated is small, the characteristic value may not be estimated accurately.

Also, when the input analog signal varies in the range from -Vref to +Vref, that is, when the maximum amplitude is Vref, a value close to $\pm$Vref/2 (i.e., a value equal to $\pm$Vref/2 or a value within a range of about $\pm$100 mV of $\pm$Vref/2) is preferably selected as the test signal value. In other words, the test signal is preferably at a level that makes the analog input/output level for the stages successive to the variable stage **11A** into which the test signal is input be about the median value of the maximum amplitude thereof. For instance, in the above example, if the input level is set at about $\pm$Vref/2, the output level will be close to zero (see FIG. **8**) and the input/output level for the successive stages will remain close to zero. When the input level is close to zero, an error in the output, occurring due to a difference in capacity value, is relatively small. Therefore, when the test signal level is set at close to $\pm$Vref/2, the digital output of the pipelined A/D converter strongly reflects an error in the output of the variable stage **11A** whose characteristic value is estimated. As a result, the characteristic value is estimated more precisely.

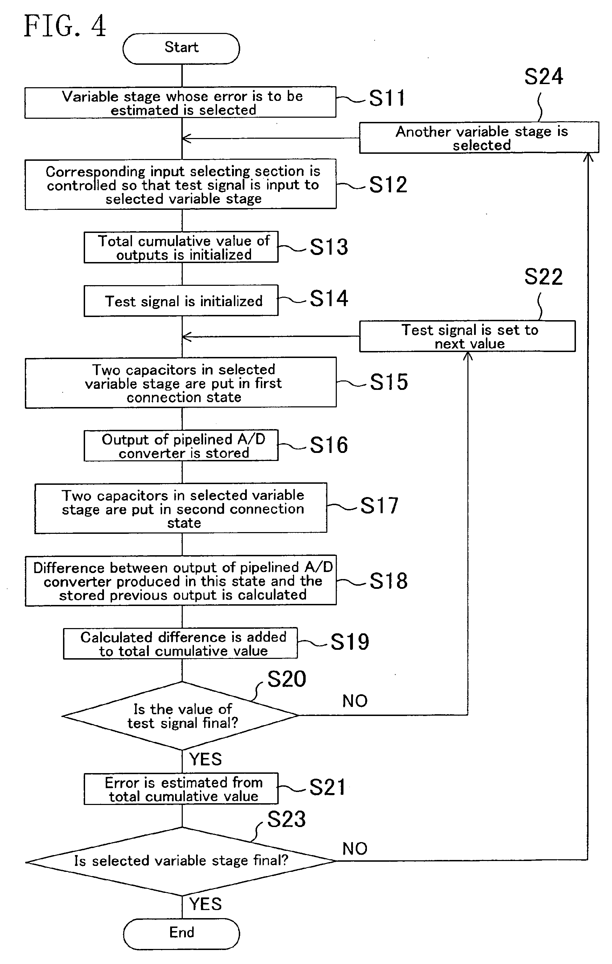

The above-mentioned process steps for estimating the characteristic value of the variable stage **11A** will be described with reference to a flow chart shown in FIG **4.** First, a variable stage **11A** whose characteristic value is to be estimated is selected (S11), and the corresponding input selecting section **14** is controlled so that a test signal is input to the selected variable stage **11A** (S12). Step **S12** corresponds to an input selecting step. Next, the total cumulative value of the digital outputs of the pipelined A/D converter is initialized (S 13), while the test signal is set to an initial value (S14). Then, the capacitors **24** and **25** in the selected variable stage **11A** are put in the first connection state (S15), and the digital output of the pipelined A/D converter produced in this state is stored (S16). Subsequently, the capacitors **24** and **25** in the selected variable stage **11A** are put in the second connection state (S17). Steps **S15** and **S17** correspond to connection state selecting steps. The difference between the digital output of the pipelined A/D converter produced in this state and the previous digital output stored in Step **S16** is calculated (S18) and added to the total cumulative value (S19). Then, it is determined whether or not the value of the test signal is final (S20), and if it is final, the characteristic value is estimated based on the total cumulative value at that time (S21). Step **S21** corresponds to an error estimation step. When the test signal value is not final, the test signal is set to a next value (S22), and the procedure returns to Step **S15**. On the other hand, after Step **S21,** it is determined whether or not the selected variable stage **11A** is final (S23). If the selected variable stage **11A** is final, the characteristic value estimation is ended, and if not, another variable stage **11A** is selected (S24) and the procedure returns to Step **S12.**

Referring back to FIG **1,** the output correction section **17** corrects the digital output of the digital calculation section **12** based on digital correction values output from the correction value calculation sections **16.** This corresponds to an output correction step. Specifically, the output correction section **17** subtracts the digital correction values output from the correction value calculation sections **16** from the digital output of the digital calculation section **12,** thereby obtaining the final digital output of the pipelined A/D converter.

The correction value calculation sections **16,** which are provided corresponding to the variable stages **11A,** each imitate the output error characteristics of the corresponding variable stage **11A** based on a characteristic value estimated by the stage evaluation section **15.** Each correction value calculation section **16** receives an output from the digital calculation section **12** and outputs an error in the digital output of the corresponding variable stage **11A** as the digital correction value. This corresponds to a correction value calculation step. Since the digital correction value calculation can be performed well based on a digital output having a relatively low resolution, each correction value calculation section **16** calculates the digital correction value based on an intermediate output from the digital calculation section **12.** The digital calculation section **12** includes digital calculation cores **121** corresponding to the respective stages. Each digital calculation core **121** adds the digital output of the corresponding stage to a digital value obtained by shifting the digital output of the stage prior to that corresponding stage by one bit. The correction value calculation sections **16** each receive a value output from the corresponding digital calculation core **121** as the intermediate output of the digital calculation section **12.** Since the digital correction values output from the respective correction value calculation sections **16** are subjected at a time to arithmetic processing performed by the output correction section **17,** delay devices **18** are provided as necessary so as to make the intermediate outputs be received by the correction value calculation sections **16** at a time.

In this embodiment as described above, for each of the variable stages **11A,** an error in output, occurring due to a difference in capacity value between the feedback and sample capacitors in the variable stage **11A,** is estimated, and a digital correction value is calculated based on the estimated error. With the digital correction values obtained in this manner, the digital output of the pipelined A/D converter is corrected. In estimating the output error for each variable stage **11A,** output errors with respect to the other stages, particularly, later stages, do not have to be eliminated in advance, thereby facilitating the output error estimation process. Moreover, since the intermediate outputs of the digital calculation section **12** are used in calculating the digital correction values, the latency of the pipelined A/D converter does not deteriorate.

It should be noted that the correction value calculation sections **16** may be designed so as to imitate reversed-polarity output error characteristics for the corresponding variable stage **11A.** In that case, the output correction section **17** adds the digital correction values output from the correction value calculation sections **16** to the digital output of the digital calculation section **12.**

It should be also noted that the stage evaluation section **15** may be designed so as to estimate the characteristic value of each variable stage **11A** based on the digital output of the digital calculation section **12,** instead of based on the digital output of the output correction section **17.** This is because errors in the outputs of the stages other than the stage whose characteristic value is estimated are canceled out by calculating a difference between the digital outputs of the digital calculation section **12.**

(Second embodiment)

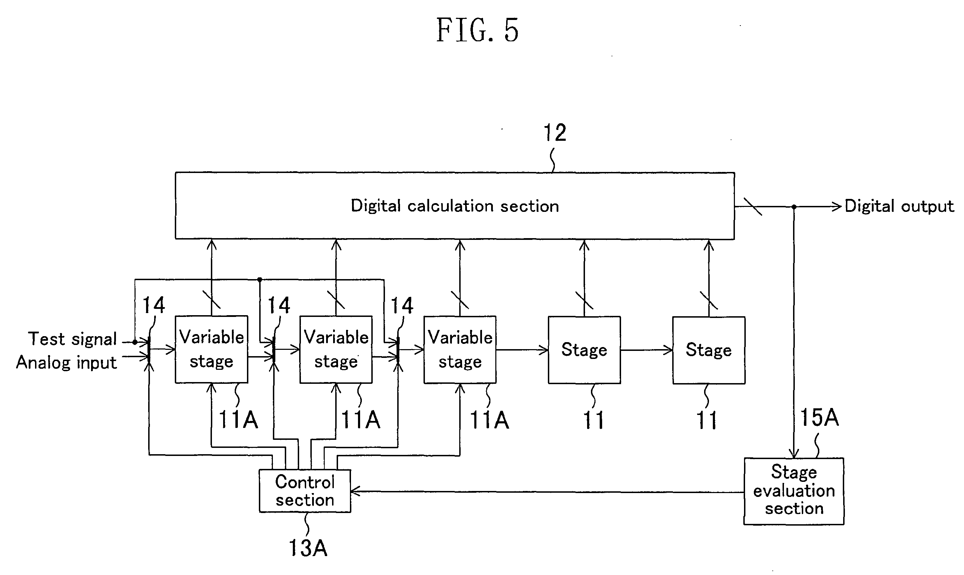

FIG. **5** illustrates the configuration of a pipelined A/D converter according to a second embodiment of the present invention. The pipelined A/D converter of this embodiment includes a plurality of cascade-connected 1.5-bit stages **11** and 1.5-bit variable stages **11A;** a digital calculation section **12;** a control section **13A;** a plurality of input selecting sections **14;** and a stage evaluation section **15A.** Of these members, the control section **13A** and the stage evaluation section **15A,** which differ from those of the first embodiment, will be described in detail. It should be noted that the respective numbers of variable stages **11A** and stages **11** illustrated in FIG. **5** are given for the convenience of description, and therefore the present invention is not limited to those configurations shown in FIG. **5.**

The stage evaluation section **15A** determines, for each variable stage **11A,** which is the greater and which is the smaller in capacity value, the feedback capacitor or the sampling capacitor, based on the digital output of the digital calculation section **12.** The configuration of each variable stage **11A** is similar to that described in the first embodiment, and FIG. **2** illustrates the inner configuration thereof.

More specifically, which capacitor has a greater capacity value and which has a smaller capacity value is determined as follows. First, with a test signal being input to an object variable stage **11A,** the digital output of the pipelined A/D converter, in which the capacitors **24** and **25** in the object variable stage **11A** are put in the first connection state, is obtained. Next, the digital output of the pipelined A/D converter, in which the capacitors **24** and **25** in the object variable stage **11A** are put in the second connection state, is obtained. Based on the relationship between these two digital outputs in terms of magnitude, which of the capacitors **24** and **25** has a greater capacity value and which has a smaller capacity value is determined.

The control section **13A** changes the connection state of the capacitors **24** and **25** in each variable stage **11A** under the control of the stage evaluation section **15A.** More specifically, the control section **13A** controls the set of switches in each variable stage **11A** in such a manner that one of the capacitors **24** and **25** that has a larger capacity value is used as the feedback capacitor.

As described above, in this embodiment, the sampling capacitor is smaller in capacity value than the feedback capacitor in each variable stage **11A,** such that an error in the output of the pipelined A/D converter is a missing code that can be corrected relatively easily.

The preferable level of the test signal is the same as described in the first embodiment. Also, as in the first embodiment, it is preferable that the comparison of the digital outputs of the pipelined A/D converter be repeated multiple times for the same variable stage **11A.**

Although the foregoing describes the embodiments of the present invention, the present invention is not limited to a pipelined A/D converter that includes 1.5-bit stages. According to the present invention, the above-described effects are achieved in a pipelined A/D converter that includes 2.5-bit stages or other stages.

As described above, the inventive pipelined A/D converters, which are capable of high-speed, high-resolution A/D conversion and have excellent INL performance, are applicable, e.g., as front end portions of digital still cameras or the like that are required to have all of these features.

**Claims**

1. A pipelined A/D converter, comprising a plurality of cascade-connected stages,
   wherein at least one of the stages is a variable stage that includes:

   an A/D converter for converting an analog input to the variable stage to digital form;
   a D/A converter for converting a digital output of the A/D converter to analog form;
   an operational amplifier;
   first and second capacitors; and
   a set of switches for selecting, as a connection state for the first and second capacitors, either a first connection state, in which the first capacitor is used for feedback of the operational amplifier and the second capacitor is used for output sampling of the D/A converter, or a second connection state that is opposite to the first connection state.

2. The pipelined A/D converter of Claim 1, further comprising:

   a digital calculation section for sequentially shifting digital outputs of the respective stages and adding resultant shifted digital values together;
   an input selecting section for selecting either a normal input signal or a test signal as the analog input to the variable stage;
   a stage evaluation section for estimating an error in an analog output of the variable stage, the error resulting from a difference in capacity value between the first and second capacitors;
   a correction value calculation section for calculating a digital correction value for correcting a digital output of the digital calculation section, based on an intermediate output of the digital calculation section and the analog output error estimated by the stage evaluation section; and
   an output correction section for correcting the digital output of the digital calculation section based on the digital correction value calculated by the correction value calculation section,

   wherein with the test signal being supplied to the variable stage, the stage evaluation section estimates the analog output error based on a difference between digital outputs of the digital calculation section or digital outputs of the output correction section produced when the first and second capacitors in the variable stage are put in the first connection state and when the first and second capacitors in the variable stage are put in the second connection state, respectively.

3. The pipelined A/D converter of Claim 2, wherein the test signal is at a level that makes the level of analog input/ output for stages successive to the variable stage into which the test signal is input be about a median value of a maximum amplitude of the analog input/output.

4. The pipelined A/D converter of Claim 1, further comprising:

an input selecting section for selecting either a normal input signal or a test signal as the analog input to the variable stage;
a control section for controlling the set of switches in the variable stage; and
a stage evaluation section for determining which of the first and second capacitors in the variable stage has a larger capacity value and which has a smaller capacity value,
wherein with the test signal being supplied to the variable stage, the stage evaluation section makes the determination about the capacity values based on digital outputs of the pipelined A/D converter produced when the first and second capacitors in the variable stage are put in the first connection state and when the first and second capacitors in the variable stage are put in the second connection state, respectively; and
the control section controls the set of switches, based on a result of the capacity-value determination made by the stage evaluation section, in such a manner that either of the first and second capacitors that has a larger capacity value is used for feedback of the operational amplifier.

5. The pipelined A/D converter of Claim 4, wherein the test signal is at a level that makes the level of analog input/ output for stages successive to the variable stage into which the test signal is input be about a median value of a maximum amplitude of the analog input/output.

6. A method for correcting an error in an output of a pipelined A/D converter that includes a plurality of cascade-connected stages and a digital calculation section for sequentially, shifting digital outputs of the respective stages and adding resultant shifted digital values together,
wherein at least one of the stages is a variable stage that includes:

an A/D converter for converting an analog input to the variable stage to digital form;
a D/A converter for converting a digital output of the A/D converter to analog form;
an operational amplifier;
first and second capacitors; and
a set of switches for selecting, as a connection state for the first and second capacitors, either a first connection state, in which the first capacitor is used for feedback of the operational amplifier and the second capacitor is used for output sampling of the D/A converter, or a second connection state that is opposite to the first connection state,
the method comprising:

an input selecting step of selecting which signal is input to the variable stage;
a connection state selecting step of performing switching between the first and second connection states for the first and second capacitors in the variable stage, with a test signal selected in the input selecting step being supplied to the variable stage;
an error estimation step of estimating an error in an analog output of the variable stage caused by a difference in capacity value between the first and second capacitors, based on a difference between outputs of the pipelined A/D converter produced when the first and second capacitors are put in the first connection state and when the first and second capacitors are put in the second connection state, respectively, in the connection state selecting step;
a correction value calculation step of calculating a digital correction value for correcting an output of the digital calculation section, based on an intermediate output of the digital calculation section and the analog output error estimated in the error estimation step; and
an output correction step of correcting the digital output of the digital calculation section based on the digital correction value calculated in the correction value calculation step.

FIG. 1

EP 1 630 964 A2

FIG. 2

# FIG. 3

# FIG. 4

```
            ( Start )
```

Variable stage whose error is to be
estimated is selected — S11

Another variable stage is
selected — S24

Corresponding input selecting section is
controlled so that test signal is input to
selected variable stage — S12

Total cumulative value of
outputs is initialized — S13

Test signal is initialized — S14

Test signal is set to
next value — S22

Two capacitors in selected
variable stage are put in first
connection state — S15

Output of pipelined A/D
converter is stored — S16

Two capacitors in selected variable
stage are put in second connection
state — S17

Difference between output of pipelined A/D
converter produced in this state and the
stored previous output is calculated — S18

Calculated difference is added
to total cumulative value — S19

S20 — Is the value of
test signal final? — NO

YES

Error is estimated from
total cumulative value — S21

S23 — Is selected variable stage final? — NO

YES

```
            ( End )
```

# FIG. 5

EP 1 630 964 A2

FIG. 6
PRIOR ART

EP 1 630 964 A2

## FIG. 7
PRIOR ART

EP 1 630 964 A2

# FIG. 8
## PRIOR ART